# EUROPEAN PATENT APPLICATION

(11) **EP 2 434 854 A1**
(43) Date of publication of application: **28.03.2012**
(21) Application number: 10306045.5
(22) Date of filing: 28.09.2010
(51) Int. Cl.: H05K 7/20

(54) **Venturi-supported double wall ventilation of free airflow cooled cabinet**

(71) Applicant: Alcatel Lucent, 75007 Paris (FR)
(72) Inventor: Pintelon, Johan, 9420, De Haan (BE); Content, Jurgen, 8370, Blankenberge (BE)
(74) Representative: ALU Antw Patent Attorneys

(57) **Abstract**

An electronic equipment cabinet having an inside including electronic equipment (EE) provided with a fan-unit (FAN). The cabinet has a first double wall (DW1) and an opposite second double wall (DW2). The first double wall comprises a first internal wall (IW1) and a first external wall (EW1), the lower side of the first external wall has a first lower outside air inlet (LI1), the upper side of this first external wall has a first upper outside air access (UI1), and the upper side of the first internal wall has a first upper inside air inlet (UO1) at the same height than the first upper outside air access. The second double wall comprises a second internal wall (IW2) and a second external wall (EW2), the lower side of the second external wall has a second lower outside air inlet (LI2), the upper side of the second external wall has an second upper outside air access (U02), and the upper side of the second internal wall has an second upper inside air access (UI2). At least the first upper outside air access (UI1) is provided with internal airflow deflectors (IV1) to create, together with the fan-unit, a Venturi effect on an inside airstream (MA1, IA2) flowing over the electronic equipment from the first towards the second double wall. The equipment is cooled without any additional fan or cooling system other than the already present fan-unit (FAN). In preferred embodiments, the other upper air access/inlets (UI1, U02, UI2) are also provided with airflow deflectors (EV1, EV2, IV2).

## Description

The present invention relates to an electronic equipment cabinet having an inside including electronic equipment provided with a fan-unit, the cabinet has a first double wall and an opposite second double wall, the first double wall comprises a first internal wall and a first external wall, the lower side of said first external wall has a first lower outside air inlet and the upper side of said first external wall has a first upper outside air access, the second double wall comprises a second internal wall and a second external wall, the lower side of said second external wall has a second lower outside air inlet and the upper side of said second external wall has an second upper outside air access, said fan-unit is configured to move an inside airstream over said electronic equipment from the first internal wall towards the second internal wall.

Such an electronic equipment cabinet is already known in the art, e.g. as a double wall outdoor cabinet that typically has ventilation/evacuation of air inside the double wall. In this cabinet, external air flows through each double wall between the internal wall and the external wall thereof from the lower outside air inlet towards to the upper outside air access/ outlet. The internal cooling of the cabinet can rely on natural convection of the internal double-wall-air, but better performance is obtained by using forced ventilation, e.g. by adding a fan under the cabinet roof, that forces air circulation inside the double walls.

However, in small cabinet deployments, using such extra fans to force ventilation in the double wall or any other cooling unit with the associated control equipment, mounting hardware, fan-alarm monitoring, maintenance, ... is adding large overhead costs.

An object of the present invention is to provide an electronic equipment cabinet of the above known type but with improved inside cooling, while avoiding the use of additional fans.

According to a characterizing embodiment of the invention, this object is achieved due to the fact that the upper side of the first internal wall has an first upper inside air inlet located at the same height on said first double wall than said first upper outside air access and provided with internal airflow deflectors, that the upper side of the second internal wall has a second upper inside air access located at the same height on said second double wall than said second upper outside air access, and that said fan-unit is adapted to generate a Venturi effect by suction of an inside airflow from said first upper inside air inlet.

In this way, the internal cooling of the electronic equipment cabinet is ensured by the fan-unit already present on the electronic equipment. This cooling is further improved by the Venturi effect created by the fan-unit in association with the upper inside air inlet and the internal airflow deflectors provided thereon.

The thermal performance, as well as the electronic lifetime, is thereby increased without any additional fan or extra active cooling equipment that should lead to additional cost and complexity.

Another characterizing embodiment of the present invention is that said second upper inside air access is provided with second internal airflow deflectors and that said fan-unit is adapted to generate a second Venturi effect over said electronic equipment by pushing an inside airflow towards said second upper outside air access through said second upper inside air access.

The second Venturi effect created by the fan-unit in associations with the second internal airflow deflectors on the second upper inside air access optimizes the cooling performances inside the cabinet.

In preferred characterizing embodiments of the present invention, said first upper outside air access and/or said second upper outside air access are also provided with first and/or second external airflow deflectors, respectively.

This increases even more the cooling of the electronic equipment by amplifying the Venturi effects.

The present invention also relates to a method for cooling an electronic equipment cabinet having an inside including electronic equipment provided with a fan-unit. The cabinet has a first double wall comprising a first internal wall and a first external wall between which a first lower in-wall outside airstream flows from a first lower outside air inlet at the lower side of said first external wall in the direction of a first upper outside air access at the upper side of said first external wall. The cabinet further has a second double wall opposite to said first double wall and comprising a second internal wall and a second external wall between which a second lower in-wall outside airstream flows from a second lower outside air inlet at the lower side of said second external wall in the direction of an second upper outside air access at the upper side of said second external wall. The fan-unit moves an inside airflow over said electronic equipment from said first internal wall towards said second internal wall.

A characteristic embodiment of the present method comprises the step of creating a Venturi effect by suction by said fan-unit of an inside airflow coming from an first upper inside air inlet located at the upper side of said first internal wall at the same height on said first double wall than said first upper outside air access and provided with internal airflow deflectors. Said inside airflow is a mixture of an incoming upper outside airstream coming from said first upper outside air access and exiting from said first upper inside air inlet, and of a first upper in-wall airstream coming from said first lower outside air inlet and also exiting from said first upper inside air inlet.

In this way, the cooling of the electronic equipment in the electronic equipment cabinet, ensured by the inside airflow moved by the fan unit is improved by the Venturi effect created by suction of fresh air coming from the first upper inside air inlet through the internal airflow deflectors.

In a preferred characterizing embodiment, said method further comprises the step of creating a second Venturi effect over said electronic equipment by pushing by said fan-unit of an inside airflow towards said second upper outside air access through said second upper inside air access, said second upper inside air access being provided with second internal airflow deflectors. A second mixed airstream is provided at the exit of said second upper outside air access, said second mixed airstream being mixture of said inside airflow flowing from said second upper inside air access to said second upper outside air access, and of a second upper in-wall airstream coming from said second lower outside air inlet.

The second Venturi effect created over the electronic equipment by the fan-unit pushing the inside airflow towards the second internal airflow deflectors of the second upper inside air access increases even more the cooling of this electronic equipment. The above-mentioned fresh air coming from the first upper inside air inlet is forced to the outside the cabinet at the top of the second double wall through the second upper inside air access and the second upper outside air access.

In other preferred characterizing embodiments of the present method, the first and/or second Venturi effects are further optimized by a providing said first upper outside air access and/or said second upper outside air access with external airflow deflectors, respectively.

Different air deflectors and air accesses/inlets designs can be realized that achieve the Venturi effects.

Further characterizing embodiments of the present electronic equipment cabinet and method for cooling the latter are mentioned in the appended claims.

It is to be noticed that the terms "comprising" or "including", used in the claims, should not be interpreted as being restricted to the means listed thereafter. Thus, the scope of an expression such as "a device comprising means A and B" should not be limited to an embodiment of a device consisting only of the means A and B. It means that, with respect to embodiments of the present invention, A and B are essential means of the device.

Similarly, it is to be noticed that the term "coupled", also used in the claims, should not be interpreted as being restricted to direct connections only. Thus, the scope of the expression such as "a device A coupled to a device B" should not be limited to embodiments of a device wherein an output of device A is directly connected to an input of device B. It means that there may exist a path between an output of A and an input of B, which path may include other devices or means.

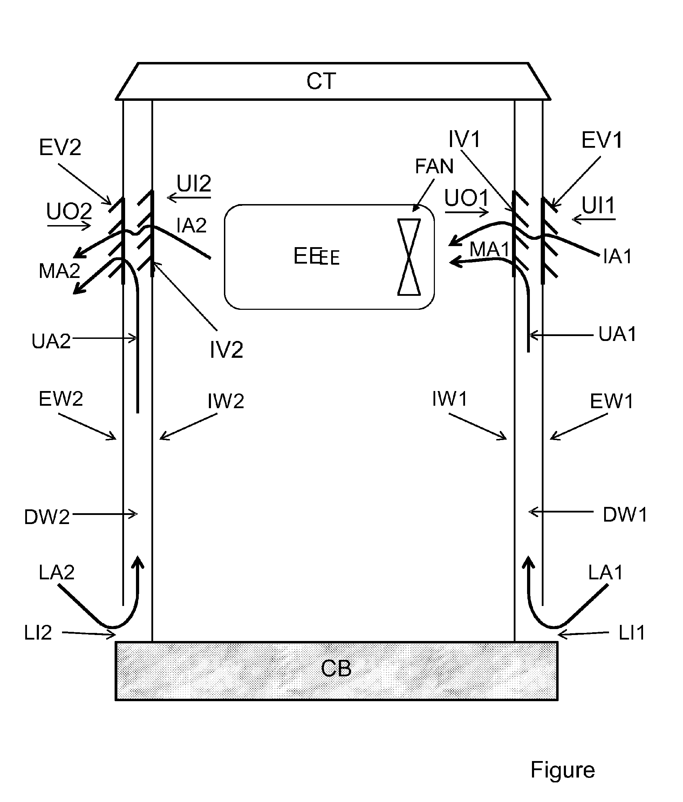

The above and other objects and features of the invention will become more apparent and the invention itself will be best understood by referring to the following description of an embodiment taken in conjunction with the accompanying drawings wherein the Figure represents a Venturi-supported double wall ventilation of free airflow cooled electronic equipment cabinet according to the invention.

The electronic equipment cabinet shown at the Figure has free air cooling interior housing electronic equipment EE. The cabinet is preferably an outside cabinet having a base CB and a top CT supported by walls. The cabinet has two opposite side wall DW1 and DW2. The first double wall DW1 has a first external wall EW1 outside the cabinet and a first internal wall IW1 inside the cabinet. Similarly, the second double wall DW2 has a second external wall EW2 outside the cabinet and a second internal wall IW2 inside the cabinet.

The lower side of the first external wall EW1 has a first lower outside air inlet LI1 and the upper side of this first external wall EW1 has a first upper outside air access UI1. Outside air can flow as an first lower in-wall outside airstream LA1 from the first lower outside air inlet LI1 in the direction of the first upper outside air access UI1 inside the first double wall DW1 between the first external wall EW1 and the first internal wall IW1 thereof.

The first internal wall IW1 has an first upper inside air inlet U01 located at the same height than the first upper outside air access UI1 of the first double wall DW1.

The lower side of the second external wall EW2 has a second lower outside air inlet LI2 and the upper side of this second external wall EW2 has a second upper outside air access U02. Outside air can flow as an second lower in-wall outside airstream LA2 from the second lower outside air inlet LI2 in the direction of the second upper outside air access U02 inside the second double wall DW2 between the second external wall EW2 and the second internal wall IW2 thereof.

The second internal wall IW2 has a second upper inside air access UI2 located at the same height than the second upper outside air access U02 of the second double wall DW2.

The electronic equipment EE inside the cabinet is provided with a fan-unit FAN that ensures an inside airflow MA1 to move over this electronic equipment EE in order to cool it. The inside airflow MA1 flows inside the cabinet from the first upper inside air inlet U01 to second upper inside air access UI2.

The thermal performance of the cabinet is increased, without adding any extra active cooling components than the fan-unit FAN already present, by the presence of internal airflow deflectors IV1 provided in the first upper inside air inlet U01.

By suction of the outside fresh air through the internal airflow deflectors IV1, the fan-unit FAN creates a Venturi effect over the electronic equipment EE. The so created Venturi effect increases the cooling of the electronic equipment EE.

The inside airflow MA1 at the exit of the first upper inside air inlet U01 is a mixture of a main incoming upper outside airstream IA1 coming from the outside via the first upper outside air access UI1 and crossing the first double wall DW1, and of a first upper in-wall airstream UA1 which is the first lower in-wall outside airstream LA1 coming from first lower outside air inlet LI1 and flowing through the first double wall DW1.

The incoming air inside the electronic equipment EE is mixed with slightly pre-heated air UA1 without excessive hotter air inlet temperatures. The pre-heated air UA1 allows to lowering the relative humidity of the outside incoming air IA1.

In a preferred embodiment, the first upper outside air access UI1 is provided with external airflow deflectors EV1. These external airflow deflectors EV1 further optimize the Venturi effect by pre-mixing the incoming upper outside airstream IA1 with the pre-heated first upper in-wall airstream UA1.

Lowering the relative humidity of the overall intake air is beneficial for lifetime of the electronic equipment EE.

The high speed main outside air inlet or first upper outside air access UI1 creates low pressure at top of the first double wall DW1. The speed of the first upper in-wall airstream UA1 is thereby increased and participates to the creation of the Venturi effect.

The second upper inside air access UI2 of the second double wall DW2 is preferably provided with second internal airflow deflectors IV2 adapted to create, together with the fan-unit FAN, a second Venturi effect over the electronic equipment EE. This second Venturi Effect is generated by the fan-unit FAN pushing the inside airflow towards the second upper outside air access U02 through second upper inside air access UI2.

A second mixed airstream MA2 is then created at the exit of second upper outside air access U02. The second mixed airstream MA2 is a mixture of an inside airflow IA2 derived from the mixed airstream MA1 flowing over the electronic equipment EE, and of a pre-heated second upper in-wall airstream UA2 which is the second lower in-wall outside airstream LA2 coming from second lower outside air inlet LI2 and flowing through the second double wall DW2.

Again the second upper outside air access U02 is preferably provided with second external airflow deflectors EV2 in order to further optimize the second Venturi effect.

The low pressure due to main air outlet or second upper outside air access U02 is sucking second double wall DW2 hot second upper in-wall airstream UA2 out. This creates a forced ventilation without any extra fan.

The high speed of the airflow MA1, IA2 at the inlet and outlet of the active cooling equipment inside the cabinet creates a low pressure airstream that will additionally extract the heated air from within the double walls DW1 and DW2 of the cabinet.

It is to be noted that the first and second Venturi effect are optimized by a suitable designs of the airflow deflectors IV, IV2, EV1 and EV2. In general, the design of these air inlets and outlets can achieve increased thermal performance of the free air cooled cabinet in such a way that no extra active cooling components are required.

It is further also to be noted that the speed regulation of the fan-unit FAN of the internal electronic equipment EE is also regulating the forced ventilation amount in the double wall DW1 and DW2, whereby no separate control logic needed.

A final remark is that embodiments of the present invention are described above in terms of functional blocks. From the functional description of these blocks, given above, it will be apparent for a person skilled in the art of designing electronic devices how embodiments of these blocks can be manufactured with well-known electronic components. A detailed architecture of the contents of the functional blocks hence is not given.

While the principles of the invention have been described above in connection with specific apparatus, it is to be clearly understood that this description is merely made by way of example and not as a limitation on the scope of the invention, as defined in the appended claims.

## Claims

1. An electronic equipment cabinet having an inside including electronic equipment (EE) provided with a fan-unit (FAN),
the cabinet has a first double wall (DW1) and an opposite second double wall (DW2),
the first double wall comprises a first internal wall (IW1) and a first external wall (EW1), the lower side of said first external wall has a first lower outside air inlet (LI1) and the upper side of said first external wall has a first upper outside air access (UI1),
the second double wall comprises a second internal wall (IW2) and a second external wall (EW2), the lower side of said second external wall has a second lower outside air inlet (LI2) and the upper side of said second external wall has an second upper outside air access U02),
said fan-unit is configured to move an inside airstream (MA1, IA2) over said electronic equipment (EE) from the first internal wall (IW1) towards the second internal wall (IW2),
***characterized in that*** the upper side of the first internal wall (IW1) has an first upper inside air inlet (UO1) located at the same height on said first double wall (DW1) than said first upper outside air access (UI1) and provided with internal airflow deflectors (IV1),
***in that*** the upper side of the second internal wall (IW2) has a second upper inside air access (UI2) located at the same height on said second double wall (DW2) than said second upper outside air access (U02),
***and in that*** said fan-unit (FAN) is adapted to generate a Venturi effect by suction of an inside airflow (MA1) from said first upper inside air inlet (UO1).

2. The cabinet according to claim 1,
***characterized in that*** said second upper inside air access (UI2) is provided with second internal airflow deflectors (IV2),
***and in that*** said fan-unit (FAN) is adapted to generate a second Venturi effect over said electronic equipment (EE) by pushing an inside airflow (IA2) towards said second upper outside air access (U02) through said second upper inside air access (UI2).

3. The cabinet according to claim **1, *characterized in that*** said first upper outside air access (UI1) is provided with first external airflow deflectors (EV1).

4. The cabinet according to claim **2, *characterized in that*** said second upper outside air access (U02) is provided with second external airflow deflectors (EV2).

5. A method for cooling an electronic equipment cabinet having an inside including electronic equipment (EE) provided with a fan-unit (FAN),
the cabinet has a first double wall (DW1) comprising a first internal wall (IW1) and a first external wall (EW1) between which a first lower in-wall outside airstream (LA1) flows from a first lower outside air inlet (LI1) at the lower side of said first external wall in the direction of a first upper outside air access (UI1) at the upper side of said first external wall,
the cabinet further has a second double wall (DW2) opposite to said first double wall (DW1) and comprising a second internal wall (IW2) and a second external wall (EW2) between which a second lower in-wall outside airstream (LA2) flows from a second lower outside air inlet (LI2) at the lower side of said second external wall in the direction of an second upper outside air access (U02) at the upper side of said second external wall,
said fan-unit (FAN) moving an inside airflow (MA1, IA2) over said electronic equipment (EE) from said first internal wall (IW1) towards said second internal wall (IW2),
***characterized in that*** said method comprises the step of creating a Venturi effect by suction by said fan-unit (FAN) of an inside airflow (MA1) coming from an first upper inside air inlet (UO1) located at the upper side of said first internal wall (IW1) at the same height on said first double wall (DW1) than said first upper outside air access (UI1) and provided with internal airflow deflectors (IV1),
***and in that*** said inside airflow (MA1, IA2) is a mixture of an incoming upper outside airstream (IA1) coming from said first upper outside air access (UI1) and exiting from said first upper inside air inlet (UO1), and a first upper in-wall airstream (UA1) coming from said first lower outside air inlet (LI1) and exiting from said first upper inside air inlet (UI1).

6. The method according to claim **5**,
***characterized in that*** said method further comprises the step of creating a second Venturi effect over said electronic equipment (EE) by pushing by said fan-unit (FAN) of an inside airflow towards said second upper outside air access (U02) through said second upper inside air access (UI2), said second upper inside air access being provided with second internal airflow deflectors (IV2),
***and in that*** a second mixed airstream (MA2) is provided at the exit of said second upper outside air access (U02), said second mixed airstream being a mixture of said inside airflow (IA2) flowing from said second upper inside air access (UI2) to said second upper outside air access (U02), and of a second upper in-wall airstream (UA2) coming from said second lower outside air inlet (LI2).

7. The method according to claim **5, *characterized in that*** the first mentioned Venturi effect is optimized by a predetermined design of said first internal airflow deflectors (IV1).

8. The method according to claim **6, *characterized in that*** said second Venturi effect is optimized by a predetermined design of said second internal airflow deflectors (IV2).

9. The method according to claim **5, *characterized in that*** the first mentioned Venturi effect is further optimized by providing said first upper outside air access (UI1) with first external airflow deflectors (EV1).

10. The method according to claim **6, *characterized in that*** said second Venturi effect is further optimized by providing said second upper outside air access (U02) with second external airflow deflectors (EV2).

## Amended claims

### Amended claims in accordance with Rule 137(2) EPC.

**1.** An electronic equipment cabinet having an inside including electronic equipment (EE) provided with a fan-unit (FAN),
the cabinet has a first double wall (DW1) and an opposite second double wall (DW2),
the first double wall comprises a first internal wall (IW1) and a first external wall (EW1), the lower side of said first external wall has a first lower outside air inlet (LI1) and the upper side of said first external wall has a first upper outside air access (U11),
the second double wall comprises a second internal wall (IW2) and a second external wall (EW2), the lower side of said second external wall has a second lower outside air inlet (LI2) and the upper side of said second external wall has an second upper outside air access UO2),
said fan-unit is configured to move an inside airstream (MA1, IA2) over said electronic equipment (EE) from the first internal wall (IW1) towards the second internal wall (IW2),
***characterized in that*** the upper side of the first internal wall (IW1) has an first upper inside air inlet (UO1) located at the same height on said first double wall (DW1) than said first upper outside air access (UI1) and provided with internal airflow deflectors (IV1),
***in that*** the upper side of the second internal wall (IW2) has a second upper inside air access (UI2) located at the same height on said second double wall (DW2) than said second upper outside air access (U02),
*and **in that*** said fan-unit (FAN) is adapted to suck outside fresh air through first upper outside air access (UI1) creating a first Venturi effect for mixing the incoming air (IA1) inside the electronic equipment with slightly pre-heated first upper in-wall air (UA1) for lowering the relative humidity, the pre-heated air (UA1) being a outside airstream (LA1) coming from first lower outside air inlet (LI1) and flowing through said first double wall (DW1).

**2.** The cabinet according to claim 1,
***characterized in that*** said second upper inside air access (UI2) is provided with second internal airflow deflectors (IV2),
*and **in that*** said fan-unit (FAN) is adapted to push an inside airflow (IA2) towards said second upper outside air access (U02) creating a second Venturi effect for mixing the inside airflow (IA2) derived from the mixed airstream (MA1) flowing over said electronic equipment (EE) with a pre-heated second upper in-wall airstream (UA2) for increasing the cooling of the electronic equipment, the pre-heated second upper in-wall airstream (UA2) being an outside airstream (LA2) coming from second lower outside air inlet (LI2) and flowing through said second double wall (DW2).

**3.** The cabinet according to claim 1, ***characterized in that*** said first upper outside air access (UI1) is provided with first external airflow deflectors (EV1).

**4.** The cabinet according to claim 2, ***characterized in that*** said second upper outside air access (U02) is provided with second external airflow deflectors (EV2).

**5.** A method for cooling an electronic equipment cabinet having an inside including electronic equipment (EE) provided with a fan-unit (FAN),
the cabinet has a first double wall (DW1) comprising a first internal wall (IW1) and a first external wall (EW1) between which a first lower in-wall outside airstream (LA1) flows from a first lower outside air inlet (LI1) at the lower side of said first external wall in the direction of a first upper outside air access (UI1) at the upper side of said first external wall,
the cabinet further has a second double wall (DW2) opposite to said first double wall (DW1) and comprising a second internal wall (IW2) and a second external wall (EW2) between which a second lower in-wall outside airstream (LA2) flows from a second lower outside air inlet (LI2) at the lower side of said second external wall in the direction of an second upper outside air access (U02) at the upper side of said second external wall,
said fan-unit (FAN) moving an inside airflow (MA1, IA2) over said electronic equipment (EE) from said first internal wall (IW1) towards said second internal wall (IW2),
***characterized in that*** said method comprises the step of creating a first Venturi effect by suction by said fan-unit (FAN) of an inside mixed airflow (MA1) coming from an first upper inside air inlet (UO1) located at the upper side of said first internal wall (IW1) at the same height on said first double wall (DW1) than said first upper outside air access (UI1) and provided with internal airflow deflectors (IV1),
***and in that*** said inside mixed airflow (MA1, IA2) is a mixture of an incoming upper outside airstream (IA1) coming from said first upper outside air access (UI1) and exiting from said first upper inside air inlet (UO1), and a slightly pre-heated first upper in-wall airstream (UA1) for lowering the relative humidity, the pre-heated airstream (UA1) being a outside airstream (LA1) coming from said first lower outside air inlet (LI1), flowing through said first double wall (DW1) and exiting from said first upper inside air inlet (UO1).

**6.** The method according to claim 5,
***characterized in that*** said method further comprises the step of creating a second Venturi effect for mixing an inside airflow (IA2) derived from the mixed airflow (MA1) flowing over said electronic equipment (EE) with a pre-heated second upper in-wall airstream (UA2) for increasing the cooling of the electronic equipment by pushing by said fan-unit (FAN) of said inside airflow (IA2) towards said second upper outside air access (U02) through said second upper inside air access (UI2), said second upper inside air access being provided with second internal airflow deflectors (IV2),
***and in that*** a second mixed airstream (MA2) is provided at the exit of said second upper outside air access (U02), said second mixed airstream being a mixture of said inside airflow (IA2) flowing from said second upper inside air access (UI2) to said second upper outside air access (U02), and of a second upper in-wall airstream (UA2) being an outside airstream (LA2) coming from said second lower outside air inlet (LI2) and flowing through said second double wall (DW2).

**7.** The method according to claim 5, ***characterized in that*** the first mentioned Venturi effect is optimized by a predetermined design of said first internal airflow deflectors (IV1).

**8.** The method according to claim 6, ***characterized in that*** said second Venturi effect is optimized by a predetermined design of said second internal airflow deflectors (IV2).

**9.** The method according to claim 5, ***characterized in that*** the first mentioned Venturi effect is further optimized by providing said first upper outside air access (UI1) with first external airflow deflectors (EV1).

**10.** The method according to claim 6, ***characterized in that*** said second Venturi effect is further optimized by providing said second upper outside air access (U02) with second external airflow deflectors (EV2).
